# EUROPEAN PATENT SPECIFICATION

(11) **EP 4 184 566 B1**
(45) Date of publication and mention of the grant of the patent: **25.02.2026**
(21) Application number: 21209345.4
(22) Date of filing: 19.11.2021
(51) Int. Cl.: H01L 23/433, H01L 23/495

(54) **A SEMICONDUCTOR DEVICE AND A METHOD OF MANUFACTURING SUCH SEMICONDUCTOR DEVICE**
HALBLEITERBAUELEMENT UND VERFAHREN ZUR HERSTELLUNG EINES SOLCHEN HALBLEITERBAUELEMENTS
DISPOSITIF À SEMI-CONDUCTEUR ET PROCÉDÉ DE FABRICATION D'UN TEL DISPOSITIF À SEMI-CONDUCTEUR

(43) Date of publication of application: 24.05.2023
(73) Proprietor: Nexperia B.V., 6534 AB Nijmegen (NL)
(72) Inventor: Yandoc, Ricardo, 6534 AB Nijmegen (NL); Chowdhury, Dilder, 6534 AB Nijmegen (NL)
(74) Representative: Pjanovic, Ilija

(56) References cited:
- CN-A- 112 117 251
- JP-A- 2016 103 616
- US-A1- 2004 012 099
- US-A1- 2012 061 816

## Description

### TECHNICAL FIELD

The present disclosure relates to a semiconductor device according to the preamble of claim 1 and a method of manufacturing such semiconductor device according to claim 3.

### BACKGROUND OF THE DISCLOSURE

A package where heat occurs at both sides of the device are known. Such packages are, for example, embedded packages, SRD dual cool packages, source down packages or inverted packages. Those packages are either difficult to manufacture or are not transferring heat efficiently to both sides of the package.

Accordingly, it is a goal of the present disclosure to provide an improved thermal performance of a semiconductor device. Furthermore the present disclosure will provide a cost effective alternative to using ceramic substrates and bare die. Also power density will improve due to PCB temperature reduction which will allow to place components closer. Relevant prior art in relation to the disclosure are:
US 2012/061816A1, which discloses a semiconductor package and method of fabricating the same, wherein the package includes an interconnection substrate, a semiconductor chip mounted on the interconnection substrate, a lateral wire bonded on the interconnection substrate and configured to enclose a side surface of the semiconductor chip, as well as a metal layer disposed on the semiconductor chip and electrically connected to the lateral wire.

US 2004/012099A1, which discloses a semiconductor device with a substrate on which a wiring pattern is formed, a semiconductor die mounted on the substrate, a sealed part sealing the semiconductor die on the substrate, and a heat sink for the semiconductor die supported above the substrate by the sealed part, with the heat sink being in electrical contact with the grounding line of semiconductor die.

JP 2016-103616A, which discloses a packaged board with a plurality of electronic elements mounted thereon disposed in an upper mold, and a tabular member with a conductor with which a protruding conductive member is formed is disposed on an inner bottom face of a cavity of a lower mold, wherein an upper part of the conductive member is exposed from a liquid-state resin that is injected into the cavity.

### SUMMARY OF THE DISCLOSURE

According to a first example of the disclosure, a semiconductor device is disclosed in accordance with the characterizing features of claim 1. It consists of a package with a first surface side and a second surface side opposite to the first surface side. The package comprises at least one semiconductor structure and a group of terminals, wherein the group of terminals is connected to the at least one semiconductor structure and mounted and exposed on the first surface side of the package. The package further comprises at least one heat slug mounted and exposed on the second surface side of the package, and at least one feedthrough wire in the package such that the feedthrough wire electrically connects with the at least one heat slug.

Preferably the semiconductor structure is a transistor.

The semiconductor structure is a cascode, wherein the cascode comprises a high-electron-mobility transistor and a metal-oxide semiconductor field-effect transistor, wherein a source terminal of the high-electron-mobility transistor is electrically connected to a drain terminal of the metal-oxide semiconductor field-effect transistor, and where a gate terminal of the high-electron-mobility transistor is electrically connected to a source terminal of the metal-oxide semiconductor field-effect transistor.

The semiconductor structures form a half bridge.

According to the characterizing part of claim 1, a first terminal is connected to the drain terminal of the high-electron-mobility transistor of a first cascode, a second terminal is electrically connected to the gate terminal of the metal-oxide semiconductor field-effect transistor of the first cascode, a third terminal is electrically connected to the source terminal of the metal-oxide semiconductor field-effect transistor and the gate terminal of the high-electron-mobility transistor of the first cascode and the drain terminal of the high-electron-mobility transistor of a second cascode, a fourth terminal is electrically connected to the gate terminal of the metal-oxide semiconductor field-effect transistor of the second cascode and the fifth terminal is electrically connected to the source terminal of the metal-oxide semiconductor field-effect transistor and the gate terminal of the high-electron-mobility transistor of the second cascode, wherein the third terminal is electrically connected with a first heat slug and the fifth terminal is electrically connected to a second heat slug.

According to a second example of the disclosure a method of manufacturing the semiconductor device according to the disclosure is proposed, the method comprising steps of:
a) preparing a lead frame having a first surface side and a second surface side opposite from the first surface side, the lead frame comprising a group of terminals of the second surface side,
b) placing at least one semiconductor structure having a first surface side and a second surface side opposite from the first surface side, with its second surface side on the first surface side of the lead frame,
c) placing at least one heat slug on the first surface side of the at least one semiconductor structure,
d) down bonding at least one feedthrough wire on at least one terminal on the first surface side of the lead frame,
e) molding the lead frame, the at least one semiconductor structure, the at least one heat slug and the at least one feedthrough into a package having a first surface side and a second surface side opposite to the first surface side,
f) exposing the at least one feedthrough wire and the at least one the heat slug through removal of a layer of material from the first surface side of the package,
g) forming an electrical connection through printing of a copper deposition on the exposed parts of the at least one heat slug and the at least one feedthrough wire,
h) plating of the printed copper deposition.

Preferably the removal step f) is performed by means of the step of polishing.

Preferably the steps a)-c) involve the step of sintering or the step of soldering.

Preferably the step b) comprises the sub-steps b1) and b2):
b1) placing as the at least one semiconductor structure at least one metal-oxide semiconductor field-effect transistor on the first surface side of the lead frame, and
b2) placing as at least one further semiconductor structure at least one high-electron-mobility transistor on the first surface side of the lead frame, such that every high-electron-mobility transistor at least partly overlaps the at least one metal-oxide semiconductor field-effect transistor.

### BRIEF DESCRIPTION OF THE DRAWINGS

The disclosure will now be discussed with reference to the drawings, which show in:
Figure 1 depicts a lead frame of a semiconductor device.
Figure 2 depicts a solder placed on the lead frame of a semiconductor device.
Figure 3 depicts first semiconductor structures placed on the lead frame of the semiconductor device.
Figure 4 depicts a solder placed on the first semiconductor structures.
Figure 5 depicts second semiconductor structures placed on the first semiconductor structures.
Figure 6 depicts a solder placed on the second semiconductor structures.
Figure 7 depicts a placing heat slugs on the second semiconductor structures.
Figure 8 depicts a feedthrough wires connected to terminals of the lead frame.
Figure 9 depicts a package comprising lead frame, the first semiconductor structures, the second semiconductor structures, the heat slugs and the feedthrough wires.
Figure 10 depicts a cross section of the semiconductor device before exposing the feedthrough wire.
Figure 11 depicts a cross section of the semiconductor device after forming an electrical connection through printing of a copper deposition on the exposed parts.
Figure 12 depicts the semiconductor device where exposed surfaces of the second semiconductor structures and the feedthrough wires have been connected with the copper deposition.
Figure 13 depicts the semiconductor where a surface of the copper deposition has been covered with a metal during plating.

### DETAILED DESCRIPTION OF THE DISCLOSURE

For a proper understanding of the disclosure, in the detailed description below corresponding elements or parts of the disclosure will be denoted with identical reference numerals in the drawings. Throughout a whole application reference numerals will refer to:
- 1: lead frame
- 1a: first surface side of lead frame
- 1b: second surface side of lead frame
- 2: solder
- 3: first semiconductor structure
- 3a: first surface side of first semiconductor structure
- 3b: second surface side of first semiconductor structure
- 4: further semiconductor structure
- 4a: first surface side of second semiconductor structure
- 4b: second surface side of second semiconductor structure
- 5: heat slug
- 6: feedthrough wire
- 7: package
- 7a: first surface side of package
- 7b: second surface side of package
- 8: copper deposition
- 9: plated surface
- 10: terminals

The disclosure is a method of assembling a source down semiconductor package with top and bottom exposed terminals using package polishing, down bonding and Cu printing method to form, HEMT gate to FET source connections.

The method is applicable in either a standard or a half bridge configuration GaN cascode or a standard product using clip bonding method, where one or two polarities located in either top or bottom of a die such as vertical products. The concept is designed for a standard dual cool package, it can also apply to a standard source down package.

Source down power packages are becoming famous due to better performance it can contribute which results in low parasitic inductance, lower package resistance and high current.

Combining a source down package with a top cooled drain (or source/gate) will increase advantage on thermal performance, either by adding heatsink on top of it, or using a water / air cooling system.

Other known advantages of introducing a source down cool package are a cost effective alternative to using ceramic substrates and bare dies, as in demanding applications such as EPS it allows the use of FR4 PCB's instead of bare die modules. Also it is a potential alternative to bare die modules in BRM systems (10-20 kW) which requires a water cooling system.

Furthermore it improves a power density, especially in dual redundant systems. Cooling HEMTs or MOSFETs from the top helps to reduce the PCB temperature. Lower PCB temperatures allows components to be placed closer to the MOSFETs

The figures depict an example of a semiconductor device according to the disclosure. It consists of a package (reference numeral 7) with a first surface side 7a and a second surface side 7b opposite to the first surface side 7a. The first surface side 7a can be the lower or bottom surface side of the package 7, whereas the second surface side 7b can be the upper or top surface side of the package 7. The package 7 further comprises at least one semiconductor structure (indicated with reference numerals 3 and 4), such as a power transistor or a half bridge, and a group of terminals 8 (10). The group of terminals 8 (10) is connected to the at least one semiconductor structure 3, 4 and are mounted and exposed on the first surface side 7a of the package 7.

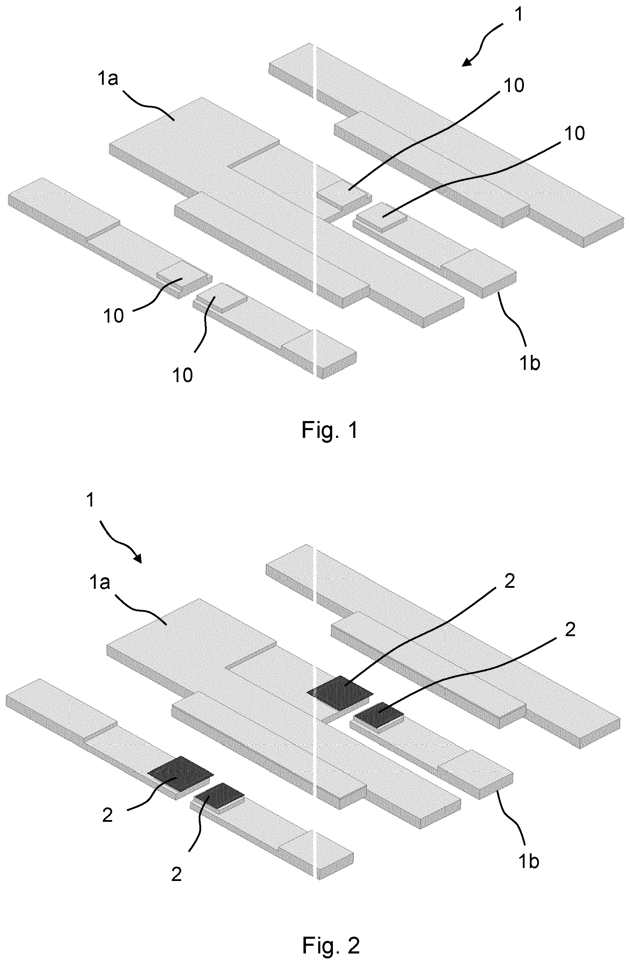

In an example shown in figs. 1-13 a cascode formed of two transistors is presented. The package 7 further comprises at least one heat slug 5 mounted and exposed on the second surface side 7b of the package 7. At least one feedthrough wire 6 is positioned in the package 7 such that the feedthrough wire 6 electrically connects with the at least one heat slug 5.

The semiconductor device, as described hereinbefore, will allow to transfer heat to both sides of a package which will allow heat dissipation more efficient. It is especially important in power devices such as a half bridge.

The semiconductor structure is a cascode which comprises a high-electron-mobility transistor and a metal-oxide semiconductor field-effect transistor, wherein a source terminal of the high-electron-mobility transistor is electrically connected to a drain terminal of the metal-oxide semiconductor field-effect transistor, and where a gate terminal of the high-electron-mobility transistor is electrically connected to a source terminal of the metal-oxide semiconductor field-effect transistor.

A first terminal is connected to the drain terminal of the high-electron-mobility transistor of a first cascode. A second terminal is electrically connected to the gate terminal of the metal-oxide semiconductor field-effect transistor of the first cascode. A third terminal is electrically connected to the source terminal of the metal-oxide semiconductor field-effect transistor and the gate terminal of the high-electron-mobility transistor of the first cascode and the drain terminal of the high-electron-mobility transistor of a second cascode. A fourth terminal is electrically connected to the gate terminal of the metal-oxide semiconductor field-effect transistor of the second cascode and the fifth terminal is electrically connected to the source terminal of the metal-oxide semiconductor field-effect transistor and the gate terminal of the high-electron-mobility transistor of the second cascode, wherein the third terminal is electrically connected with a first heat slug and the fifth terminal is electrically connected to a second heat slug.

Below a method according to the disclosure is presented for manufacturing the semiconductor device as described hereinbefore. In a first step, denoted as step a, a lead frame 1 is prepared as shown in fig. 1. The lead frame 1 has a first surface side 1a and a second surface side 1b opposite from the first surface side 1a. The lead frame 1 comprises a group of terminals 10 on the second surface side 1b. Those terminals 10 will be connected to at least one semiconductor structure 3.

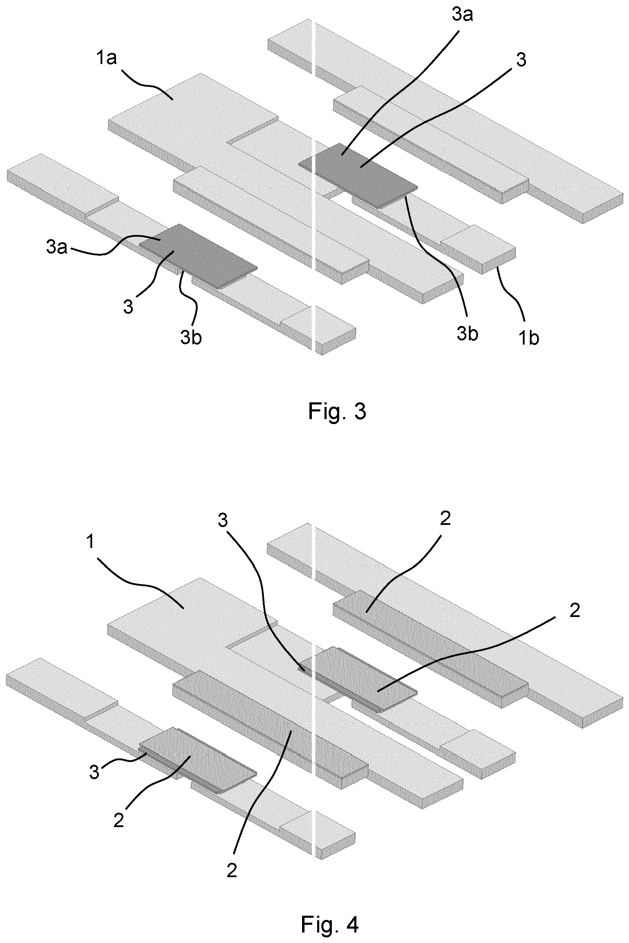

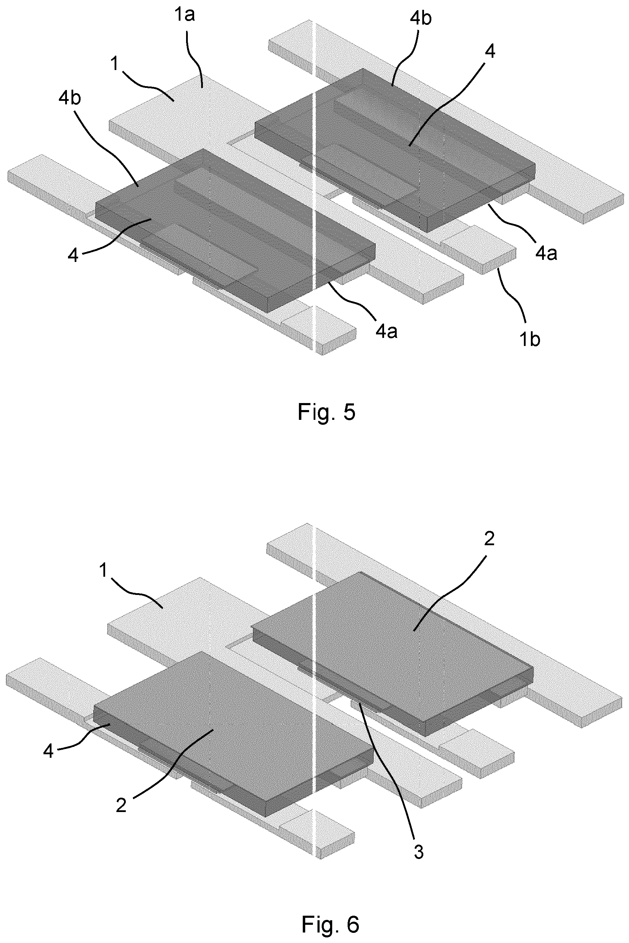

During a second step, step b, at least one first semiconductor structure 3 each having a first surface side 3a and a second surface side 3b opposite from the first surface side 3a, is placed with its second surface side 3b on the first surface side 1a of the lead frame 1, as it is shown in fig. 3. It should be noted that more first semiconductor structures 3 may be placed, on a lead frame 1 and/or on other semiconductor structures 3, as it is shown in fig. 5. In such a case, step b comprises the sub-steps b1 and b2. During step b1 at least one semiconductor structure 3, preferably being at least one metal-oxide semiconductor field-effect transistor, is placed on the first surface side 1a of the lead frame 1. As a next step, step b2 is performed where at least one further semiconductor structure 4, preferably at least one high-electron-mobility transistor, is placed on the first surface side 1a of the lead frame 1, wherein the at least one further semiconductor structure 4 at least partly overlaps the at least one semiconductor structure 3.

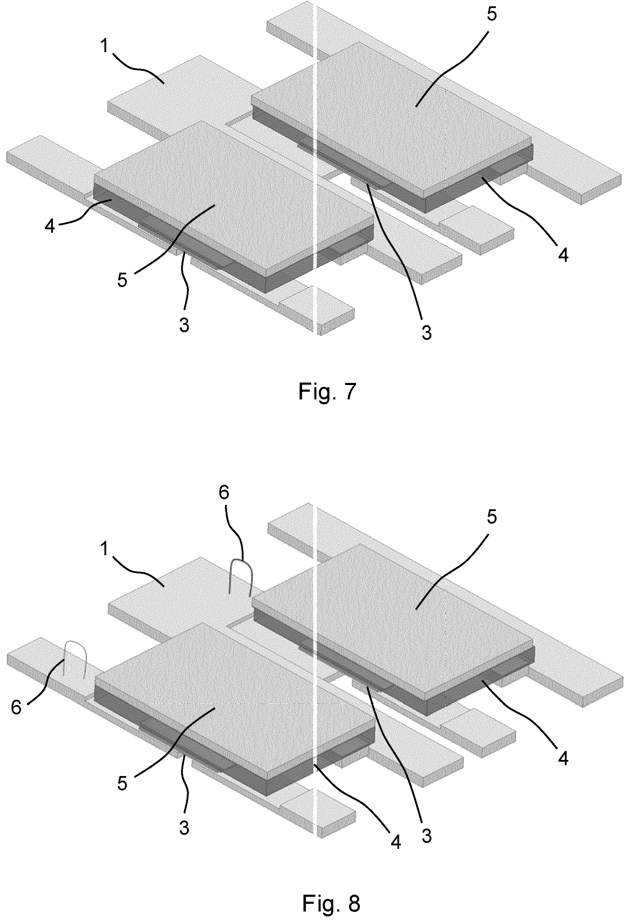

Next, step c of the method according to the disclosure is performed, wherein at least one heat slug 5 is placed on the first surface side 3a-4a of the at least one semiconductor structure 3, 4. This is shown in fig. 7.

During a further step, denoted as step d of the method according to the disclosure, at least one feedthrough wire 6 is down bonded on at least one terminal on the second surface side 1b of the lead frame 1, as it is shown in fig. 8. It should be noted that step c of placing at least one heat slug 5 on the first surface side 3a-4a of the at least one semiconductor structure 3, 4 may be performed after step d. Also the at least one feedthrough wire 6 may be in form of a loop, as shown in fig. 8.

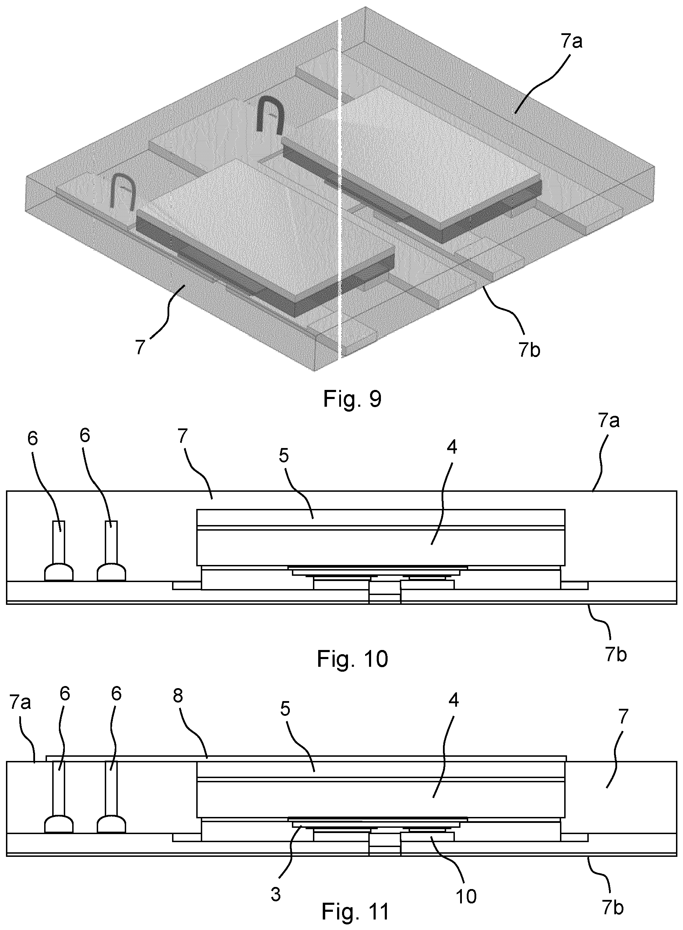

Next, during step e of the method according to the disclosure, a package 7 is made by molding the lead frame 1, the at least one semiconductor structure 3, 4, the at least one heat slug 5 and the at least one feedthrough wire 6 into a package having a first surface side 7a and a second surface side 7b opposite to the first surface side 7a. The package 7 thus obtained is shown in fig. 9.

During a next step of the method according to the disclosure, denoted as step f, the at least one feedthrough wire 6 and the at least one the heat slug 5 are exposed from the first surface side 7a. This step f is performed by removing a layer of material from the first surface side 7a of the package 7. Preferably it is done by polishing of the first (top) surface side 7a of a package 7.

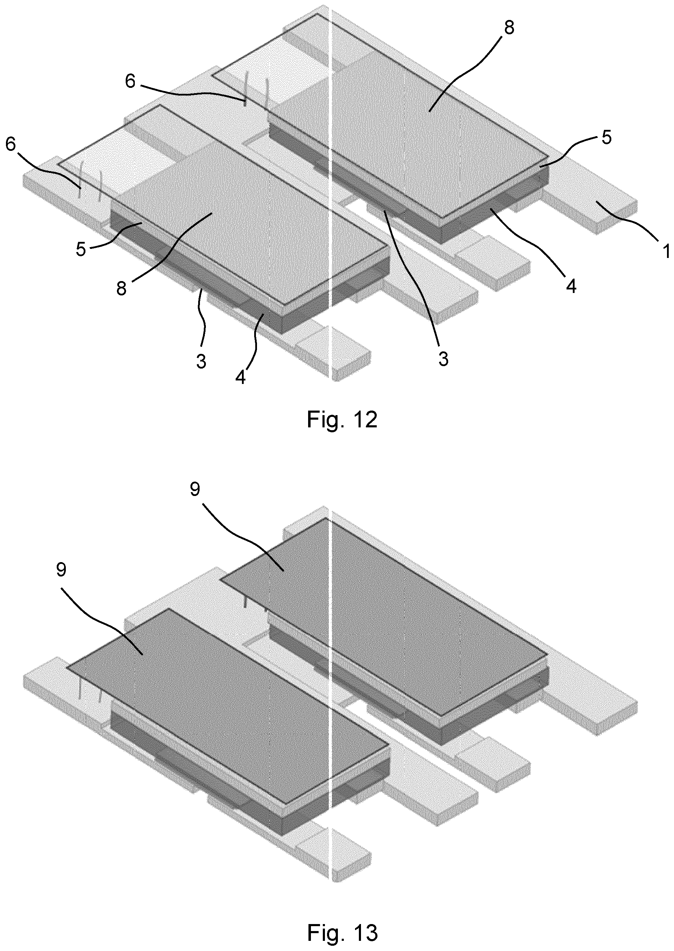

During a following step g of the method according to the disclosure, the forming of an electrical connection is performed. This electrical connection is formed by printing a copper deposition 8 on the exposed parts of the at least one heat slug 5 and the at least one feedthrough wire 6. The result of step g is shown in fig. 12.

The last step, step h, results in plating of the printed copper deposition 8 with a plating material resulting in a plated surface 9 in or on the first surface 7a of the package, as shown in fig. 13.

In figs. 12 and 13 the package 7 is not shown for a clarity reasons. It should be however noted that the shown structure is enclosed within the package 7 as shown in figs. 9, 10 and 11.

In a further detailed example of the disclosure, the steps a-c involve the step of sintering or the step of soldering. This is shown in figs. 2, 4, 6.

## Claims

1. A semiconductor device consisting of a package (7) with a first surface side (7a) and a second surface side (7b) opposite to the first surface side (7a), the package (7) comprising at least one semiconductor structure (3, 4) and a group of terminals (10),
wherein the group of terminals (10) is connected to the at least one semiconductor structure (3, 4) and mounted and exposed on the first surface side (7a) of the package (7),
the package (7) further comprising at least one heat slug (5) mounted and exposed on the second surface side (7b) of the package (7), and
at least one feedthrough wire (6) in the package (7) such that the feed through wire (6) electrically connects with the at least one heat slug (5), **characterised in that** the semiconductor structure (3, 4) forms a half bridge and is a cascode comprising a high-electron-mobility transistor and a metal-oxide semiconductor field-effect transistor, wherein a source terminal of the high-electron-mobility transistor is electrically connected to a drain terminal of the metal-oxide semiconductor field-effect transistor, and where a gate terminal of the high-electron-mobility transistor is electrically connected to a source terminal of the metal-oxide semiconductor field-effect transistor, wherein
a first terminal is connected to the drain terminal of the high-electron-mobility transistor of a first cascode, a second terminal is electrically connected to the gate terminal of the metal-oxide semiconductor field-effect transistor of the first cascode, a third terminal is electrically connected to the source terminal of the metal-oxide semiconductor field-effect transistor and the gate terminal of the high-electron-mobility transistor of the first cascode and the drain terminal of the high-electron-mobility transistor of a second cascode, a fourth terminal is electrically connected to the gate terminal of the metal-oxide semiconductor field-effect transistor of the second cascode and the fifth terminal is electrically connected to the source terminal of the metal-oxide semiconductor field-effect transistor and the gate terminal of the high-electron-mobility transistor of the second cascode, wherein the third terminal is electrically connected with a first heat slug and the fifth terminal is electrically connected to a second heat slug.

2. The semiconductor device according to claim 1, wherein the semiconductor structure is a transistor.

3. A method of manufacturing the semiconductor device according to claim 1 or 2, the method comprising steps of:
a) preparing a lead frame (1) having a first surface side (1a) and a second surface side (1b) opposite from the first surface side (1a), the lead frame (1) comprising a group of terminals (10) on the second surface side (1b),
b) placing at least one semiconductor structure (3, 4) having a first surface side (3a, 4a) and a second surface side (3b, 4b) opposite from the first surface side (3a, 4a), with its second surface side (3b, 4b) on the first surface side (1a) of the lead frame (1),
c) placing at least one heat slug (5) on the first surface side (3a, 4a) of the at least one semiconductor structure (3, 4),
d) down bonding at least one feedthrough wire (6) on at least one terminal (10) on the first surface side (1a) of the lead frame (1), **characterised by the steps of**
e) molding the lead frame (1), the at least one semiconductor structure (3, 4), the at least one heat slug (5) and the at least one feedthrough wire (6) into a package (7) having a first surface side (7a) and a second surface side (7b) opposite to the first surface side (7a),
f) exposing the at least one feedthrough wire (6) and the at least one heat slug (5) through removal of a layer of material from the first surface side (7a) of the package (7),
g) forming an electrical connection through printing of a copper deposition (8) on the exposed parts of the at least one heat slug (5) and the at least one feedthrough wire (6),
h) plating (9) of the printed copper deposition (5).

4. The method according to claim 3, wherein removal step f) Is performed by means of the step of polishing.

5. The method according to claim 3 or 4, wherein steps a)-d) involve the step of sintering or the step of soldering.

6. The method according to any one of claim 3-5, wherein step b) comprises the sub-steps b1) and b2):
b1) placing as the at least one semiconductor structure (3) at least one metal-oxide semiconductor field-effect transistor on the first surface side (1a) of the lead frame (1), and
b2) placing as at least one further semiconductor structure (4) at least one high-electron-mobility transistor on the first surface side (1a) of the lead frame (1), such that every high-electron-mobility transistor at least partly overlaps the at least one metal-oxide semiconductor field-effect transistor.

## Patentansprüche

1. Halbleitervorrichtung, die aus einem Gehäuse (7) mit einer ersten Oberflächenseite (7a) und einer zweiten Oberflächenseite (7b), die von der ersten Oberflächenseite (7a) abgewandt ist, besteht, wobei das Gehäuse (7) mindestens eine Halbleiterstruktur (3, 4) und eine Gruppe von Anschlüssen (10) umfasst,
wobei die Gruppe von Anschlüssen (10) mit der mindestens einen Halbleiterstruktur (3, 4) verbunden und auf der ersten Oberflächenseite (7a) des Gehäuses (7) montiert und freigelegt ist,
wobei das Gehäuse (7) ferner mindestens eine Wärmeableitplatte (5), die auf der zweiten Oberflächenseite (7b) des Gehäuses (7) montiert und freigelegt ist, und
mindestens einen Durchführungsdraht (6) in dem Gehäuse (7) umfasst, sodass der Durchführungsdraht (6) mit der mindestens einen Wärmeableitplatte (5) elektrisch verbunden ist,
**dadurch gekennzeichnet, dass**
die Halbleiterstruktur (3, 4) eine Halbbrücke bildet und eine Kaskode ist, die einen High-Electron-Mobility-Transistor und einen Metalloxid-Halbleiter-Feldeffekttransistor umfasst, wobei ein Source-Anschluss des High-Electron-Mobility-Transistors mit einem Drain-Anschluss des Metalloxid-Halbleiter-Feldeffekttransistors elektrisch verbunden ist und wobei ein Gate-Anschluss des High-Electron-Mobility-Transistors mit einem Source-Anschluss des Metalloxid-Halbleiter-Feldeffekttransistors elektrisch verbunden ist, wobei
ein erster Anschluss mit dem Drain-Anschluss des High-Electron-Mobility-Transistors einer ersten Kaskode verbunden ist, ein zweiter Anschluss mit dem Gate-Anschluss des Metalloxid-Halbleiter-Feldeffekttransistors der ersten Kaskode elektrisch verbunden ist, ein dritter Anschluss mit dem Source-Anschluss des Metalloxid-Halbleiter-Feldeffekttransistors und dem Gate-Anschluss des High-Electron-Mobility-Transistors der ersten Kaskode und dem Drain-Anschluss des High-Electron-Mobility-Transistors einer zweiten Kaskode elektrisch verbunden ist, ein vierter Anschluss mit dem Gate-Anschluss des Metalloxid-Halbleiter-Feldeffekttransistors der zweiten Kaskode elektrisch verbunden ist und der fünfte Anschluss mit dem Source-Anschluss des Metalloxid-Halbleiter-Feldeffekttransistors und dem Gate-Anschluss des High-Electron-Mobility-Transistors der zweiten Kaskode elektrisch verbunden ist, wobei der dritte Anschluss mit einer ersten Wärmeableitplatte elektrisch verbunden ist und der fünfte Anschluss mit einer zweiten Wärmeableitplatte elektrisch verbunden ist.

2. Halbleitervorrichtung nach Anspruch 1, wobei die Halbleiterstruktur ein Transistor ist.

3. Verfahren zum Herstellen der Halbleitervorrichtung nach Anspruch 1 oder 2, wobei das Verfahren die folgenden Schritte umfasst:
a) Anfertigen eines Leiterrahmens (1) mit einer ersten Oberflächenseite (1a) und einer zweiten Oberflächenseite (1b), die von der ersten Oberflächenseite (1a) abgewandt ist, wobei der Leiterrahmen (1) eine Gruppe von Anschlüssen (10) auf der zweiten Oberflächenseite (1b) umfasst,
b) Platzieren mindestens einer Halbleiterstruktur (3, 4) mit einer ersten Oberflächenseite (3a, 4a) und einer zweiten Oberflächenseite (3b, 4b), die von der ersten Oberflächenseite (3a, 4a) abgewandt ist, sodass sich ihre zweite Oberflächenseite (3b, 4b) auf der ersten Oberflächenseite (1a) des Leiterrahmens (1) befindet,
c) Platzieren mindestens einer Wärmeableitplatte (5) auf der ersten Oberflächenseite (3a, 4a) der mindestens einen Halbleiterstruktur (3, 4),
d) Aufbonden mindestens eines Durchführungsdrahts (6) auf mindestens einem Anschluss (10) auf der ersten Oberflächenseite (la) des Leiterrahmens (1), **gekennzeichnet durch** die folgenden Schritte:
e) Formen des Leiterrahmens (1), der mindestens einen Halbleiterstruktur (3, 4), der mindestens einen Wärmeableitplatte (5) und des mindestens einen Durchführungsdrahts (6) zu einem Gehäuse (7) mit einer ersten Oberflächenseite (7a) und einer zweiten Oberflächenseite (7b), die von der ersten Oberflächenseite (7a) abgewandt ist,
f) Freilegen des mindestens einen Durchführungsdrahts (6) und der mindestens einen Wärmeableitplatte (5) durch das Entfernen einer Schicht eines Materials von der ersten Oberflächenseite (7a) des Gehäuses (7),
g) Bilden einer elektrischen Verbindung durch das Aufbringen einer Kupferbeschichtung (8) auf den freigelegten Teilen der mindestens einen Wärmeableitplatte (5) und des mindestens einen Durchführungsdrahts (6),
h) Plattieren (9) der aufgebrachten Kupferbeschichtung (5).

4. Verfahren nach Anspruch 3, wobei der Entfernungsschritt f) mittels eines Polierschritts durchgeführt wird.

5. Verfahren nach Anspruch 3 oder 4, wobei die Schritte a)-d) einen Sinterschritt oder einen Lötschritt einschließen.

6. Verfahren nach einem der Ansprüche 3-5, wobei der Schritt b) die Teilschritte b1) und b2) umfasst:
b1) Platzieren, als die mindestens eine Halbleiterstruktur (3), mindestens eines Metalloxid-Halbleiter-Feldeffekttransistors auf der ersten Oberflächenseite (1a) des Leiterrahmens (1) und
b2) Platzieren, als mindestens eine weitere Halbleiterstruktur (4), mindestens eines High-Electron-Mobility-Transistors auf der ersten Oberflächenseite (1a) des Leiterrahmens (1), sodass jeder High-Electron-Mobility-Transistor den mindestens einen Metalloxid-Halbleiter-Feldeffekttransistor zumindest teilweise überdeckt.

## Revendications

1. Dispositif à semi-conducteur consistant en un boîtier (7) pourvu d'un côté première surface (7a) et d'un côté deuxième surface (7b) opposé au côté première surface (7a), le boîtier (7) comprenant au moins une structure semi-conductrice (3, 4) et un groupe de bornes (10),
dans lequel 1e groupe de bornes (10) est connecté à l'au moins une structure semi-conductrice (3, 4) et monté et exposé sur le côté première surface (7a) du boîtier (7),
le boîtier (7) comprenant en outre au moins un dissipateur thermique (5) monté et exposé sur le côté deuxième surface (7b) du boîtier (7), et
au moins un fil de connexion d'interface (6) dans le boîtier (7) de telle sorte que le fil de connexion d'interface (6) se connecte électriquement avec l'au moins un dissipateur thermique (5), **caractérisé en ce que** la structure semi-conductrice (3, 4) forme un demi-pont et est un cascode comprenant un transistor à haute mobilité électronique et un transistor à effet de champ à semi-conducteur à oxyde métallique, dans lequel une borne de source du transistor à haute mobilité électronique est électriquement connectée à une borne de drain du transistor à effet de champ à semi-conducteur à oxyde métallique, et une borne de grille du transistor à haute mobilité électronique est électriquement connectée à une borne de source du transistor à effet de champ à semi-conducteur à oxyde métallique, dans lequel
une première borne est connectée à la borne de drain du transistor à haute mobilité électronique d'un premier cascode, une deuxième borne est électriquement connectée à la borne de grille du transistor à effet de champ à semi-conducteur à oxyde métallique du premier cascode, une troisième borne est électriquement connectée à la borne de source du transistor à effet de champ à semi-conducteur à oxyde métallique et la borne de grille du transistor à haute mobilité électronique du premier cascode et la borne de drain du transistor à haute mobilité électronique d'un deuxième cascode, une quatrième borne est électriquement connectée à la borne de grille du transistor à effet de champ à semi-conducteur à oxyde métallique du deuxième cascode et la cinquième borne est électriquement connectée à la borne de source du transistor à effet de champ à semi-conducteur à oxyde métallique et la borne de grille du transistor à haute mobilité électronique du deuxième cascode, la troisième borne étant électriquement connectée à un premier dissipateur thermique et la cinquième borne étant électriquement connectée à un deuxième dissipateur thermique.

2. Dispositif semi-conducteur selon la revendication 1, dans lequel la structure semi-conductrice est un transistor.

3. Procédé de fabrication d'un dispositif semi-conducteur selon la revendication 1 ou 2, le procédé comprenant les étapes consistant à :
a) préparer une grille de connexion (1) ayant un côté première surface (1a) et un côté deuxième surface (1b) opposé au côté première surface (1a), la grille de connexion (1) comprenant un groupe de bornes (10) sur le côté deuxième surface (1b),
b) placer au moins une structure semi-conductrice (3, 4) ayant un côté première surface (3a, 4a) et un côté deuxième surface (3b, 4b) opposé au côté première surface (3a, 4a), son côté deuxième surface (3b, 4b) se trouvant sur le côté première surface (1a) de la grille de connexion (1),
c) placer au moins un dissipateur thermique (5) sur le côté première surface (3a, 4a) de l'au moins une structure semi-conductrice (3, 4),
d) lier par la face avant au moins un fil de connexion d'interface (6) sur au moins une borne (10) sur le côté première surface (1a) de la grille de connexion (1), **caractérisé par** les étapes consistant à
e) mouler la grille de connexion (1), l'au moins une structure semi-conductrice (3, 4), l'au moins un dissipateur thermique (5) et l'au moins un fil de connexion d'interface (6) en un boîtier (7) ayant un côté première surface (7a) et un côté deuxième surface (7b) opposé au côté première surface (7a),
f) exposer l'au moins un fil de connexion d'interface (6) et l'au moins un dissipateur thermique (5) par suppression d'une couche de matière depuis le côté première surface (7a) du boîtier (7),
g) former une connexion électrique par impression d'un dépôt de cuivre (8) sur les parties exposées de l'au moins un dissipateur thermique (5) et de l'au moins un fil de connexion d'interface (6),
h) plaquer (9) le dépôt de cuivre imprimé (5).

4. Procédé selon la revendication 3, dans lequel l'étape de suppression f) est réalisée au moyen de l'étape de polissage.

5. Procédé selon la revendication 3 ou 4, dans lequel les étapes a) à d) implique l'étape de frittage ou l'étape de brasage.

6. Procédé selon l'une quelconque des revendications 3 à 5, dans lequel l'étape b) comprend les sous-étapes b1) et b2) :
b1) placer en tant que l'au moins une structure semi-conductrice (3) au moins un transistor à effet de champ à semi-conducteur à oxyde métallique sur le côté première surface (1a) de la grille de connexion (1), et
b2) placer en tant qu'au moins une autre structure semi-conductrice (4) au moins un transistor à haute mobilité électronique sur le côté première surface (1a) de la grille de connexion (1), de telle sorte que chaque transistor à haute mobilité électronique recouvre au moins partiellement l'au moins un transistor à effet de champ à semi-conducteur à oxyde métallique.
